# EUROPEAN PATENT APPLICATION

(11) **EP 2 202 026 A1**
(43) Date of publication of application: **30.06.2010**
(21) Application number: 09011989.2
(22) Date of filing: 21.09.2009
(51) Int. Cl.: B23K 26/00, B23K 26/40, B23K 26/08, B23K 26/42

(54) **Laser processing apparatus and method for manufacturing thin-film solar cells**

(30) Priority: 25.12.2008 JP 2008329267
(71) Applicant: Hitachi High-Technologies Corporation, Tokyo 105-8717 (JP)
(72) Inventor: Yamaguchi, Hironaru, Tokyo 100-8220 (JP); Hongo, Mikio, Tokyo 100-8220 (JP); Koizumi, Mitsuyoshi, Tokyo 100-8220 (JP); Araki, Masaki, Tokyo 100-8220 (JP)
(74) Representative: Strehl Schübel-Hopf & Partner

(57) **Abstract**

A laser processing apparatus which achieves both shorter Turn Around Time (TAT) and reduction in processing defects. In the apparatus, a laser radiation section (4,5,6), an undulation measurement section (11,12) for measuring undulation of a substrate or a film thickness measuring section for measuring the thickness of a thin film formed on the substrate, and an optical inspection section (10) for optically inspecting grooves formed by laser-processing the thin film on the substrate are fixed so that their positional relationship is kept constant.

## Description

### FIELD OF THE INVENTION

The present invention relates to laser processing apparatuses for processing thin film.

### BACKGROUND OF THE INVENTION

For the manufacture of thin-film solar cells having amorphous silicon thin film, microcrystal silicon thin film and/or transparent electrodes, Japanese Patent Application Laid-Open Publication No. 2005-235920 discloses a technique that laser beams are used to process such thin film. Also, Japanese Patent Application Laid-Open Publication No. 8(1996)-37317 describes a defect detection method for thin-film solar cells and Japanese Patent Application Laid-Open Publication No. 2(1990)-281133 describes a system which locates a short circuit defect between electrodes or wirings in a thin-film semiconductor device and repairs it.

### SUMMARY OF THE INVENTION

In techniques of manufacturing thin-film solar cells which use amorphous silicon or microcrystal silicon, a sheet electricity-generating layer and transparent conductive film are separated like islands and divided into cells and the cells are connected in series in order to obtain a high voltage. In this process, the spacing between cells for division should be minimized to reduce area loss. As a technique for dividing the film into cells, microfabrication by laser light is useful. However, the use of laser light for dividing the film into cells may cause such problems as low fabrication yields and failures to achieve specific characteristics. If the laser processing accuracy is low, insulation between cells may be inadequate, resulting in a failure to attain a specific voltage level and a decline in electricity generation efficiency. The laser processing accuracy is considered to be influenced by inter-pulse variation in laser light intensity, film thickness, substrate undulation and so on.

Japanese Patent Application Laid-Open Publication No. 2005-235920 proposes a quality control system based on a combination of a laser processing apparatus and an inspection device and Japanese Patent Application Laid-Open Publication No. 8(1996)-37317 and Japanese Patent Application Laid-Open Publication No. 2(1990)-281133 propose methods for detecting poor insulation using infrared rays and microplasma emissions respectively. However, when an inspection step is newly added as described in the above documents, an increase in TAT (Turn Around Time) is inevitable. In addition, if a film is reprocessed to repair a defective part, time to transport the substrate between steps is required and the processing apparatus is occupied for reprocessing, leading to a significant time loss.

An object of the present invention is to provide a laser processing apparatus which achieves both shorter TAT and reduction in processing defects.

According to one aspect of the present invention, as a laser processing apparatus which achieves both reduction in processing defects and shorter TAT, there is provided a laser processing apparatus including a stage for carrying a substrate on which a thin film is formed, a drive for scanning the substrate, and a laser radiation section for irradiating laser light on the thin film formed on the substrate placed on the stage to form grooves in the thin film, characterized by further including at least one of the following: an undulation measurement section for measuring undulation of the substrate, a film thickness measurement section for measuring the thin film's thickness, an optical inspection section for inspecting the grooves optically, and an electrical inspection section for inspecting the grooves electrically, wherein, if at least one of the undulation measurement section, the film thickness measurement section, and the optical inspection section is included, it and the laser radiation section are fixed so that their positional relationship is kept constant.

Accordingly, the present invention provides a laser processing apparatus which achieves both reduction in processing defects and shorter TAT.

### BRIEF DESCRIPTION OF THE DRAWINGS

Fig. 1 is a view showing a laser processing apparatus according to a first embodiment of the invention as viewed from the y direction;
Fig. 2 is a view showing the laser processing apparatus according to the first embodiment as viewed from the x direction;
Fig. 3 is a view showing the laser processing apparatus according to the first embodiment as viewed from the z direction;
Figs. 4A to 4G are views showing a process of manufacturing solar cell thin film, in which Fig. 4A shows a substrate preparation step, Fig. 4B shows a step of forming transparent conductive film on the substrate, Fig. 4C shows a step of processing the transparent conductive film, Fig. 4D shows a step of forming an electricity-generating layer, Fig. 4E shows a step of processing the electricity-generating layer, Fig. 4F shows a step of forming conductive film, and Fig. 4G shows a step of processing a laminate of the conductive film and electricity-generating layer;
Figs. 5A to 5C are views showing different operation phases in the first embodiment, in which Fig. 5A illustrates undulation measurement of the substrate, Fig. 5B illustrates undulation measurement of the substrate and laser radiation, and Fig. 5C illustrates undulation measurement of the substrate, laser radiation, and inspection of processed grooves;
Fig. 6 is a view showing details of an optical inspection section according to a second embodiment of the invention;
Fig. 7A is a view showing the shape of a laser-processed groove in the second embodiment and Fig. 7B is a view showing output data from the optical inspection section in the second embodiment;
Fig. 8 is a view showing details of an optical inspection section according to a third embodiment of the invention;
Fig. 9A is a view showing the shape of a laser-processed groove in the third embodiment and Fig. 9B is a view showing output data from the optical inspection section in the third embodiment;
Fig. 10 is a view showing a laser processing apparatus according to a fourth embodiment of the invention as viewed from the y direction;
Fig. 11 is a view showing the laser processing apparatus according to the fourth embodiment as viewed from the x direction;
Fig. 12A is a view showing the appearance of processed grooves in the fourth embodiment and Fig. 12B is a view showing the result of resistance measurement in the fourth embodiment;
Fig. 13 is a view showing a laser processing apparatus according to a fifth embodiment of the invention as viewed from the y direction;
Fig. 14 is a view showing a laser processing apparatus according to a sixth embodiment of the invention as viewed from the x direction;
Fig. 15 is a view showing a laser processing apparatus according to a seventh embodiment of the invention as viewed from the z direction;
Fig. 16 is a time diagram of a process including movement of the stage, measurement, processing, and inspection in a case that there is no processing defect;
Fig. 17 is a time diagram of a process including movement of the stage, measurement, processing, and inspection in a case that reprocessing is done to repair a processing defect;
Fig. 18 is a time diagram of a process including movement of the stage, measurement, processing, and inspection in a case that there is a processing defect and the substrate is discarded; and
Fig. 19 is a time diagram of a process including movement of the stage, measurement, processing, and inspection in a case that there is no processing defect.

### DETAILED DESCRIPTION OF THE PREFERRED EMBODIMENTS

Next, the preferred embodiments of the present invention will be described.

### First Embodiment

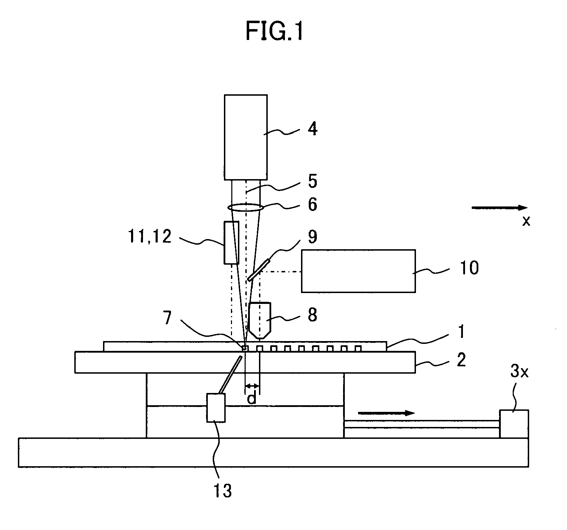

A first embodiment of the invention is described below referring to Figs. 1 to 3, Figs. 4A to 4G and Figs. 5A to 5C.

Figs. 1, 2 and 3 show the apparatus according to the first embodiment as viewed from the y direction, x direction and z direction, respectively. Reference numeral 1 denotes a substrate, 2 a stage, 3x an x-axis moving mechanism, 3y a y-axis moving mechanism, 4 a laser optics system, 5 laser light, 6 a condenser lens, 7 laser-processed grooves, 8 an objective lens, 9 a mirror, 10 an observation device, 11 a displacement gauge light source, 12 a photo-detector for the displacement gauge, 13 a mechanism for blowing off foreign matter, 14 a focusing mechanism, and 15 a base. The laser radiation section includes the laser optics system 4 and condenser lens 6. The optical inspection section includes the objective lens 8, mirror 9, and observation device 10. The undulation measurement section includes the displacement gauge light source 11 and displacement gauge photo-detector 12.

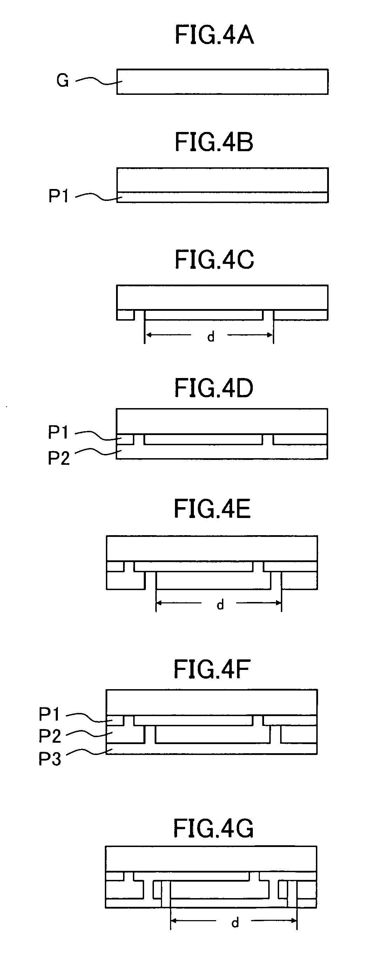

Figs. 4A to 4G show a process of forming solar cell thin film to be processed in this embodiment. Fig. 4A shows a glass substrate G as the film base and Fig. 4B shows that transparent conductive film P1 is formed on it. Fig. 4C shows that the transparent conductive film P1 is irradiated with laser light at regular intervals of d to form grooves. Fig. 4D shows that an electricity-generating layer P2 is formed on the film P1. Fig. 4E shows that the layer P2 is also irradiated with laser light at regular intervals of d to form grooves, in the same way as the film P1. Then, conductive film P3 is formed on the layer P2 as shown in Fig. 4F and the film P3 is irradiated with laser light at regular intervals of d to form grooves as shown in Fig. 4G. In this way, solar cells are formed at regular intervals of d. Finally, a high electromotive force can be generated by connecting the cells in series. The transparent conductive film P1 may be ZnO or SnO film and the electricity-generating layer P2 may be amorphous silicon film, microcrystal silicon film or a laminate of both.

The films P1, P2, and P3 are different in light transmittance and generally 1064 nm laser light is used for P1 and 532 nm laser light is used for P2 and P3. In this process, laser radiation is needed three times, or at the steps in Figs. 4C, 4E, and 4G. Laser radiation is carried out by irradiating the substrate 1 with laser light from the laser optics system 4 shown in Fig. 1. The laser processing apparatus according to this embodiment can be applied to any of the films P1 to P3 at the steps in Figs. 4C, 4E, and 4G. Although it is not necessary to use this laser processing apparatus for all the films P1 to P3, the maximum benefit from the apparatus can be obtained by doing so.

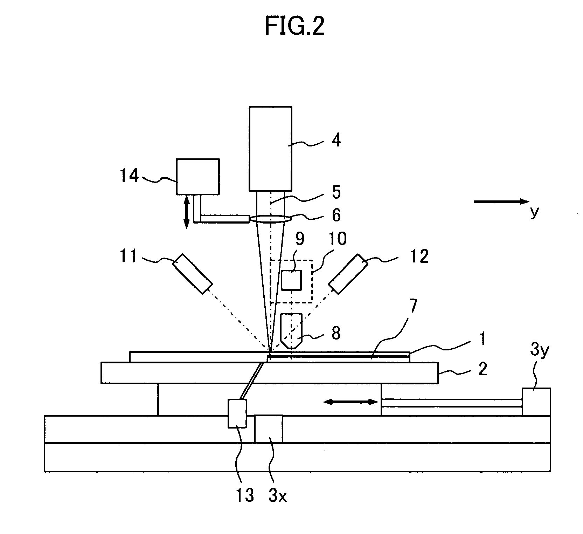

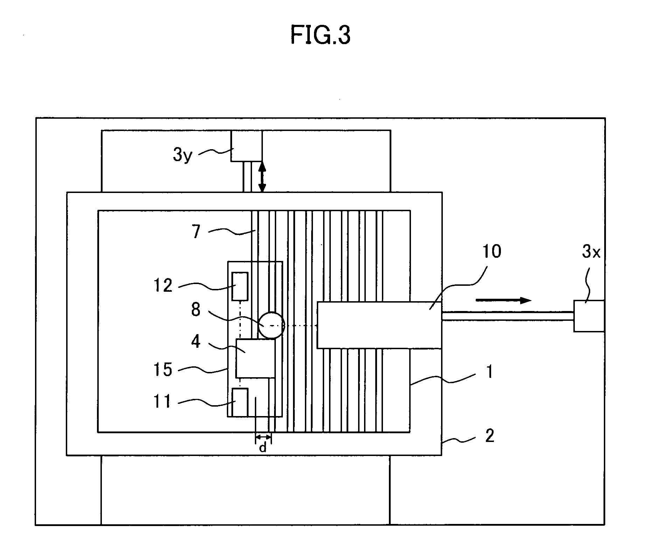

Referring to Figs. 2 and 3, as the stage 2 is moved in the y direction by the y-axis moving mechanism 3y, the substrate 1 on which thin film is coated is irradiated (scanned) with laser light 5 to form laser-processed grooves 7. As illustrated in Figs. 1 and 3, each time the stage 2 is traveled once in the y direction for scanning, the x-axis moving mechanism 3x moves the stage 2 in the x direction by a given distance d so that laser-processed grooves 7 are formed at regular intervals of d. The mechanism for blowing off foreign matter 13 is designed to blow off leavings in the grooves 7.

As illustrated in Fig. 1, the centerline of the objective lens 8 of the optical inspection section is spaced by distance d from the centerline of the condenser lens 6 of the laser radiation section in the +x direction. As mentioned above, the distance d corresponds to the width of each solar cell. Light from the objective lens 8 is led through the mirror 9 into the observation device 10. As a consequence, the width, depth, and roughness of the processed grooves 7 can be optically observed.

As illustrated in Fig. 1, the displacement gauge light source 11 and displacement gauge photo-detector 12 are located so that the point of undulation measurement is spaced by distance d from the centerline of the condenser lens 6 in the -x direction. As a consequence, undulation of the substrate 1 can be measured.

As illustrated in Fig. 3, the laser optics system 4, condenser lens 6 (hidden in the figure), objective lens 8, displacement gauge light source 11, and displacement gauge photo-detector 12 are fixed on the base 15 and kept in a given positional relationship.

For thin-film solar cells, the distance d is usually 10 mm or so. The distance is enough to install the objective lens 8, displacement gauge light source 11, and displacement gauge photo-detector 12. If the distance d is smaller than this, the spacing between the objective lens 8 and the condenser lens 6 may be md (m: an integer) and the spacing between the displacement gauge light source 11/displacement gauge photo-detector 12 and the condenser lens 6 may be nd (n: an integer). In this case, time lag between processing and observation or time lag between undulation measurement and processing may be increased but the operation cycle is the same as above.

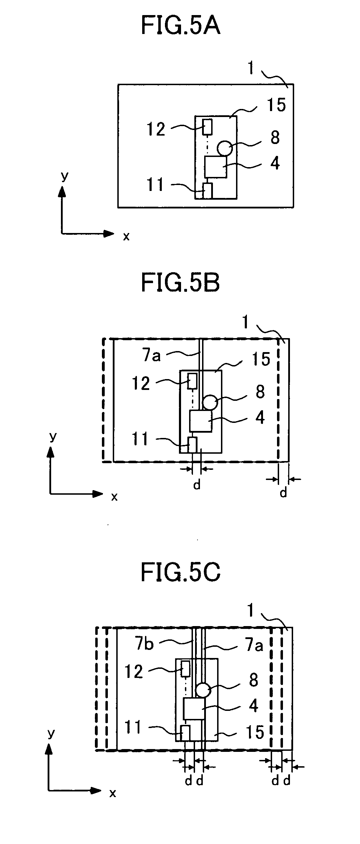

Figs. 5A to 5C show how laser radiation, observation of processed grooves 7, and undulation measurement of the substrate 1 are carried out. In the figures, only key elements among the elements shown in Fig. 3 are shown and different steps (A to C) are illustrated in chronological order. As mentioned above, the laser optics system 4, condenser lens 6 (hidden in the figure), objective lens 8, displacement gauge light source 11, and displacement gauge photo-detector 12 are fixed on the base 15 and kept in a given positional relationship.

Fig. 5A shows a phase in which grooves are not formed yet. At this phase, undulation of a portion of the substrate 1 to be processed is measured by the displacement gauge light source 11 and displacement gauge photo-detector 12.

Fig. 5B shows that the substrate 1 has moved to the right by distance d from its position shown in Fig. 5A. At this phase, laser light is emitted from the laser optics system 4 and the substrate 1 is moved upward as viewed in the figure so that a processed groove 7a is formed. At the same time, undulation measurement of a substrate portion to be processed next is carried out by the displacement gauge light source 11 and displacement gauge photo-detector 12.

Fig. 5C shows that the substrate 1 has moved to the right by distance d from its position shown in Fig. 5B. At this phase, a new groove 7b is formed in the same sequence as in Fig. 5B and at the same time, undulation measurement of a substrate portion to be processed next is carried out by the displacement gauge light source 11 and displacement gauge photo-detector 12. Furthermore, at the phase shown in Fig. 5C, the processed groove 7a is observed by the observation device 10.

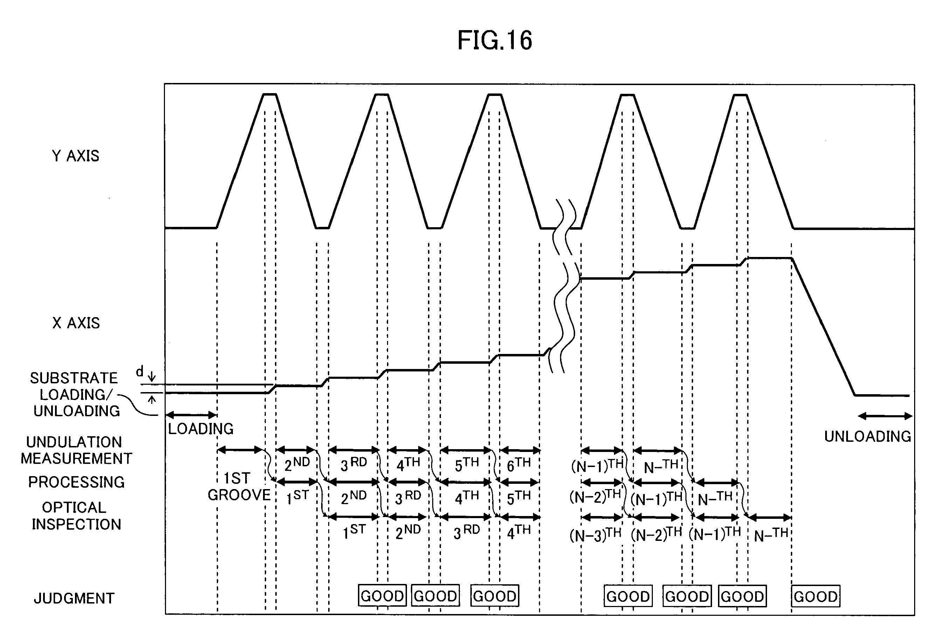

Figs. 16, 17 and 18 are time diagrams concerning different steps: movement of the stage, undulation measurement, processing, and inspection.

Fig. 16 shows a case that the entire substrate has been processed normally. The stage repeatedly reciprocates in the y direction in a way that processing or inspection can be performed from one end of the substrate to the other. The stage moves in the x direction by distance d each time the stage arrives at an end of the substrate in the y direction. Thus, grooves are formed at regular intervals of distance d. After a given number (N) of grooves are formed and inspected, the process is finished and the substrate 1 is unloaded. In the process, the steps of undulation measurement, processing, and optical inspection are temporally staggered, or performed simultaneously for different grooves. This makes it possible that undulation measurement is made before processing and the result of measurement is reflected in the processing conditions or an inspection is made immediately after processing to decide whether the groove is good or not. If the objective lens 8 of the optical inspection section, the condenser lens 6 of the laser radiation section, and the point of undulation measurement are at the same coordinate in the y direction, the distance of movement in the y direction is minimized. In this embodiment, which gives it priority that the distance between the objective lens 8 of the optical inspection section and the condenser lens 6 of the laser radiation section is d in the x direction, the objective lens 8 of the optical inspection section and the condenser lens 6 of the laser radiation section are at different coordinates in the y direction.

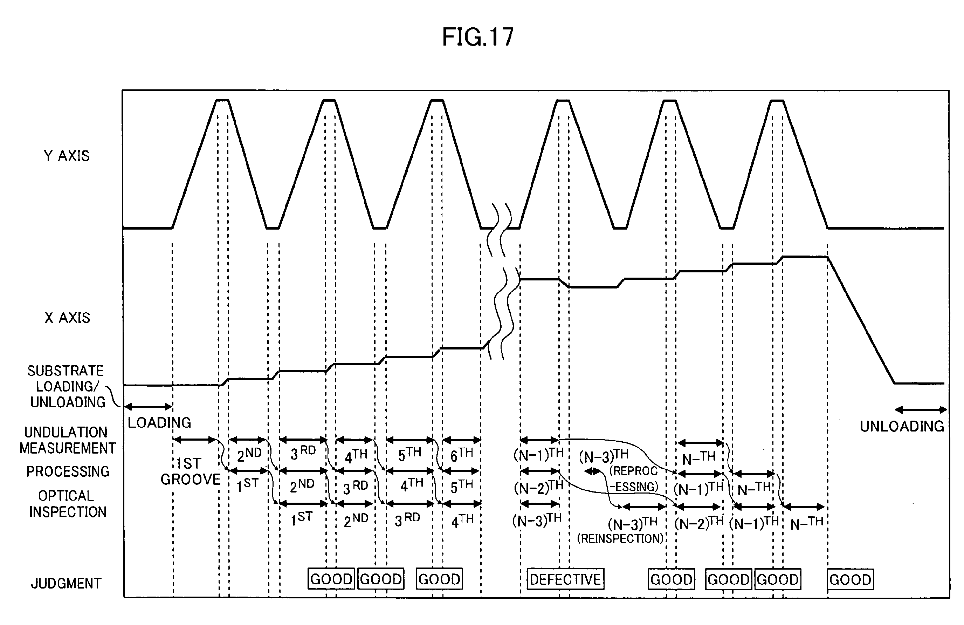

Fig. 17 shows a case that there is a processing defect. Since a processing defect occurs in the (N-3)th groove, the stage is moved back to the defective part. After the defective part is reprocessed, the (N-3)th groove is inspected again. If it is found to be good, processing for the (N-1)th groove is started.

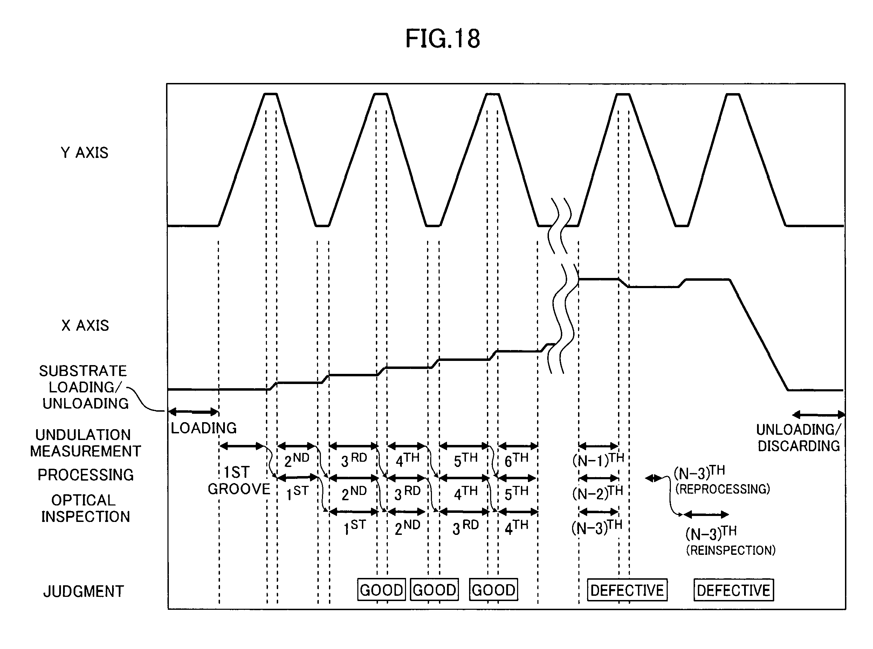

Fig. 18 shows a case that the reprocessed (N-3)th groove is found to be not good. In this case, the defect is decided to be irreparable and, the substrate 1 is unloaded and discarded without proceeding to subsequent steps.

According to this embodiment, since the undulation measurement section and the laser radiation section are fixed and kept in a given positional relationship, the result of undulation measurement is accurately reflected in the point of laser radiation and the focal position, so processing defects can be drastically reduced. Therefore, post-processing inspection can be omitted as needed. In addition, since undulation measurement and laser radiation can be performed almost simultaneously, TAT can be shortened.

Furthermore, since the optical inspection section and the laser radiation section are fixed and kept in a given positional relationship, if a defect is found by optical inspection, the defect can be easily located and reprocessing can be quickly started. Thus it is easy to repair a defect and it is also possible to omit the step of measurement before laser radiation as needed. In addition, since optical inspection and laser radiation can be performed almost simultaneously, TAT can be shortened.

Furthermore, according to this embodiment, three steps, namely displacement measurement, laser radiation, and observation, can be performed simultaneously. Since the same stage is used to scan the substrate 1 in these three steps, the target spots for laser radiation, observation, and displacement measurement can be aligned with each other without the need for any special means such as a marker and alignment with the same spot can be made accurately. Therefore, as compared with a conventional system in which substrate undulation measurement and observation of processed grooves are performed by devices other than a laser processing apparatus, the overall process time can be substantially shortened and processed grooves can be inspected accurately.

Since the result of observation is obtained just after laser processing in this way, a defect can be detected at an early stage of the process. Specifically, if a defect is found by observation, the defective part can be moved back to beneath the condenser lens 6 to irradiate it with laser light again and blow off foreign matter. If the substrate 1 is found to be irreparable, it can be discarded immediately. If a defect is found in the process for P1, the defect concerned can be prevented from proceeding to the processes for P2 and P3 without being repaired. Consequently, waste in processing is substantially reduced as compared with a case that an inspection is made after completion of all the processes for P1 to P3.

In addition, the result of undulation measurement of the substrate 1 can be quickly reflected in the laser processing conditions. Specifically, by changing the vertical position or height of the condenser lens 6 according to the result of measurement by the displacement gauge photo-detector 12, laser light is always focused on the target spot of the film properly even if the substrate 1 is considerably wavy or undulating. For example, if laser light5 is condensed on a spot of tens of microns and the spot is tens of microns away from the target spot, blurring will occur, resulting in a processing defect. This embodiment solves this problem and prevents occurrences of processing defects.

In other words, since the undulation measurement section, laser radiation section and processed groove inspection section are provided, processing defects are reduced and even if a defect should occur, an action to address it can be quickly taken, so there is no need to transport the substrate between processes and processing time is substantially reduced. Inspection of processed grooves and undulation measurement can be performed almost simultaneously with laser radiation, so TAT can be shortened.

Although undulation of the substrate 1 is measured in this embodiment, the displacement gauge light source 11 and displacement gauge photo-detector 12 may be replaced by a film thickness measuring instrument. If that is the case, the film thickness distribution of the substrate is measured before processing, so, even if there is a considerable change in film thickness, the laser light intensity can be set according to the change in film thickness and thus processing defects can be substantially reduced. Furthermore, since it does not matter that such a film thickness measuring instrument is installed along with the displacement gauge light source 11 and displacement gauge optical photo-detector 12, it is also possible to specify the processing conditions according to both the substrate undulation and film thickness distribution.

As described above, in this embodiment, processing defects can be quickly detected and processing defects can be reduced, leading to a significant improvement in the yield and TAT in the manufacture of solar cells.

In addition, the instruments can be integrated into a compact unit.

Also, since it is easy to align the processing point, the inspection point and the point of substrate undulation measurement or film thickness measurement with the same point, the yield can be improved without special efforts.

Also, since a defective part can be repaired or discarded at an early stage, waste in processing time can be reduced.

### Second Embodiment

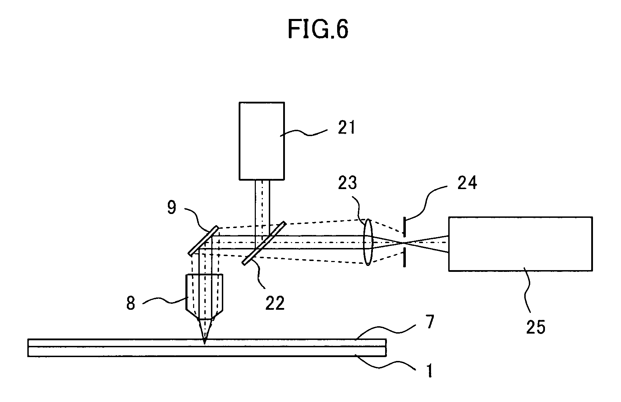

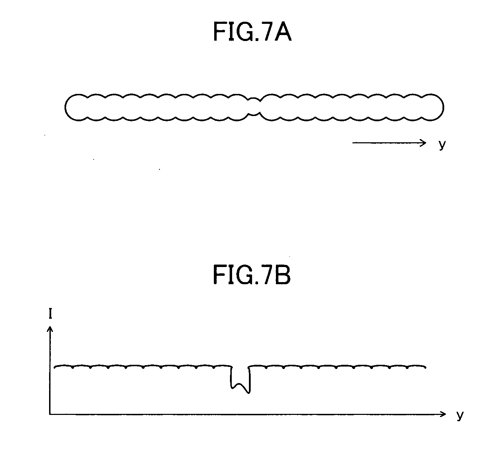

Next, an example of optical inspection as a second embodiment of the invention will be explained referring to Fig. 6 and Figs. 7A and 7B. Regarding things that have been described concerning the first embodiment and are not described below, they also hold true for the second embodiment.

Fig. 6 shows details of an optical inspection section according to the second embodiment; and Fig. 7A shows the shape of a laser-processed groove and Fig. 7B shows output data from a detector 25 of the optical inspection section. In Fig. 6, reference numeral 1 denotes a substrate and 7 denotes a processed groove. The optical inspection section includes an objective lens 8 and mirror 9 as in the first section and also includes, as components of an observation device, a laser light source for observation 21, translucent mirror 22, lens 23, aperture 24, and detector 25. When the focal point of the lens 23 is aligned with the aperture 24, the device functions as a confocal laser scanning microscope. As illustrated in Fig. 6, the focal point of the objective lens 8 is adjusted to the required depth of the processed groove 7 and if the actually processed groove 7 has the required depth, light passes through light paths indicated by solid lines and a large quantity of light passes through the aperture 24; on the other hand, if the groove 7 does not have the required depth, light passes through light paths indicated by dotted lines and the quantity of light passing through the aperture 24 is small. This means that change in the depth of the processed groove 7 can be detected by change in the quantity of light entering the detector 25. The thicknesses of the transparent conductive film and electricity-generating layer are usually hundreds of nanometers and when the film has a thickness of this order, its cut depth can be measured by the confocal laser scanning microscope.

The light quantity distribution in the y direction for the processed groove shown in Fig. 7A is shown in Fig. 7B as an example. Here, processing of the film P1 is taken as an example. The inside of the pattern shown in Fig. 7A represents a laser-processed portion of the conductive thin film and the area surrounding it represents an unprocessed portion of it. Each circle in the pattern (processed portion) corresponds to one pulse of laser light. In Fig. 7B, the horizontal axis y represents the y coordinate and the vertical axis I represents the intensity of light as detected by the confocal laser scanning microscope. The circle whose radius is smaller than the radii of other circles in Fig. 7A corresponds to a processing defect attributable to an accidental drop in laser light intensity. Fig. 7B demonstrates that there is a drop in light intensity which corresponds to the processing defect and suggests that the depth of the processed groove is insufficient at that spot. A processing defect can be quickly detected in this way and the defective part can be reprocessed promptly or if it seems irreparable, the substrate can be discarded immediately.

Therefore, according to the second embodiment, the defective part can be located easily and can be reprocessed quickly or a decision to discard the substrate can be made immediately. In addition, since optical inspection and laser radiation can be performed almost simultaneously, TAT can be shortened. Furthermore, the use of the confocal laser scanning microscope for the optical inspection section makes it possible to provide a high resolution in the depth direction and easily detect a change in the groove depth. Moreover, since laser light is irradiated on the thin film without passing through the glass substrate 1 and light is thus not absorbed by the glass substrate 1, a suitable wavelength of laser light for the thin film material can be selected. In addition, in the manufacture of solar cells, the yield and TAT can be substantially improved.

### Third Embodiment

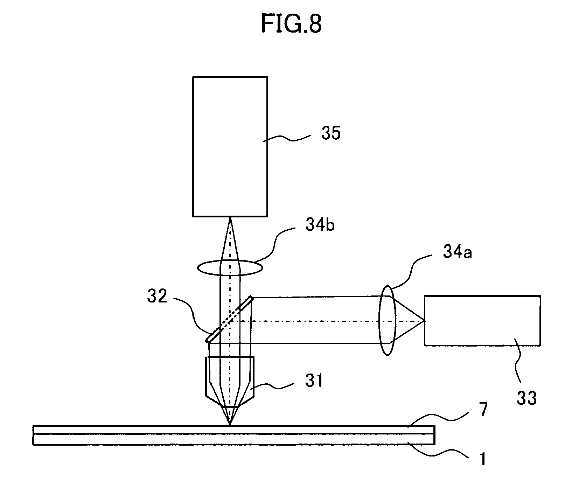

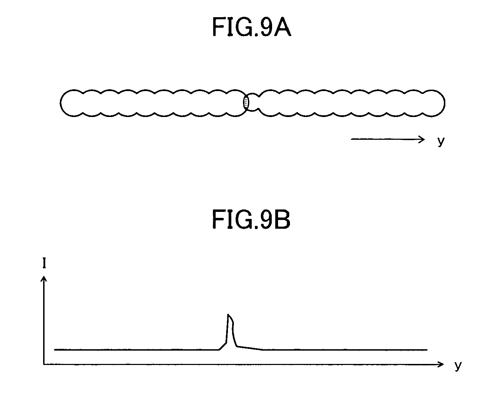

Next, another example of optical inspection as a third embodiment will be explained referring to Fig. 8 and Figs. 9A and 9B. Regarding things that have been described concerning the first embodiment and are not described below, they also hold true for the third embodiment.

Fig. 8 shows details of an optical inspection section according to the third embodiment. In Fig. 8, reference numeral 1 denotes a substrate and 7 denotes a processed groove. The optical inspection section includes a dark-field objective lens 31, mirror with a hole 32, lenses 34a and 34b, light source 33 and detector 35.

This embodiment uses a dark-field microscope as an observation device. Through this microscope, a surface roughness of the processed groove or leavings on it which would be invisible through an ordinary microscope can be detected. Therefore, inadequate cuts in laser-processed grooves or adhesion of foreign matter can be easily located.

The light quantity distribution in the y direction for the processed groove shown in Fig. 9A is shown in Fig. 9B as an example. The inside of the pattern shown in Fig. 9A represents a laser-processed portion of the conductive thin film and the area surrounding it represents an unprocessed portion of it. Each circle in the processed portion corresponds to one pulse of laser light. In Fig. 9B, the horizontal axis y represents the y coordinate and the vertical axis I represents the intensity of light as detected by the dark-field microscope. The dark spot in the groove as shown in Fig. 9A corresponds to a film residue which results from a processing defect attributable to an accidental drop in laser light intensity. Fig. 9B demonstrates that due to light scattering, the light intensity at this spot is higher than in its surroundings. A processing defect can be quickly detected in this way and the defective part can be reprocessed promptly or if it seems irreparable, the substrate can be discarded immediately.

Therefore, according to the third embodiment, the defective part can be located easily and can be reprocessed quickly or a decision to discard the substrate can be made immediately. In addition, since optical inspection and laser radiation can be performed almost simultaneously, TAT can be shortened. Furthermore, the use of the dark-field microscope for the optical inspection section makes it easy to detect a surface roughness of the processed groove or leavings on it. Moreover, since laser light is irradiated on the thin film without passing through the glass substrate 1 and light is thus not absorbed by the glass plate, a suitable wavelength of laser light for the thin film material can be selected. In addition, in the manufacture of solar cells, the yield and TAT can be substantially improved.

### Fourth Embodiment

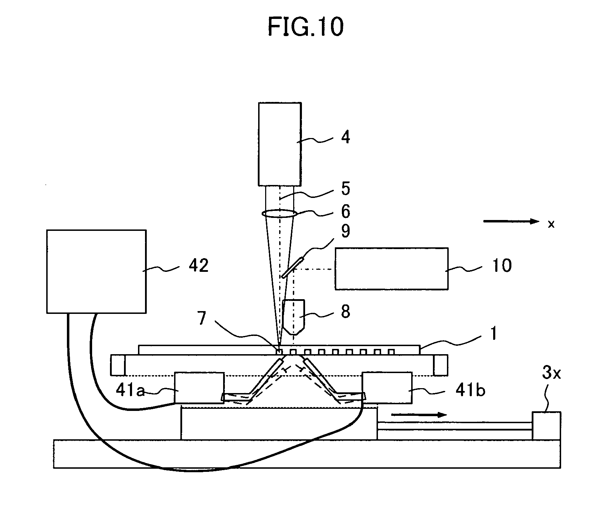

Next, an example of electrical inspection as a fourth embodiment will be explained referring to Fig. 10, Fig. 11 and Figs. 12A and 12B. Regarding things that have been described concerning the first to third embodiments and are not described below, they also hold true for the fourth embodiment.

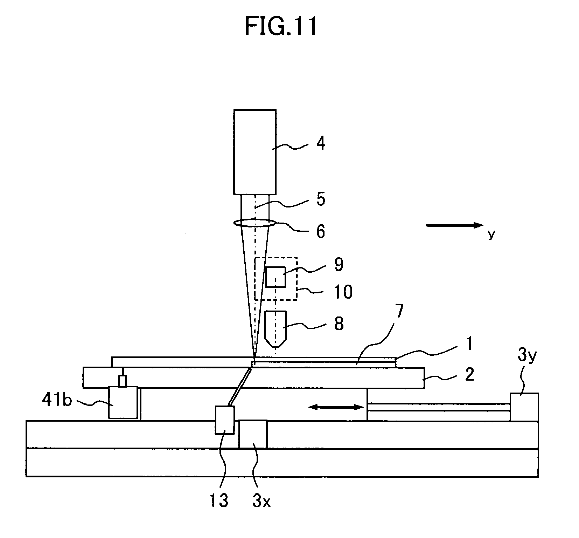

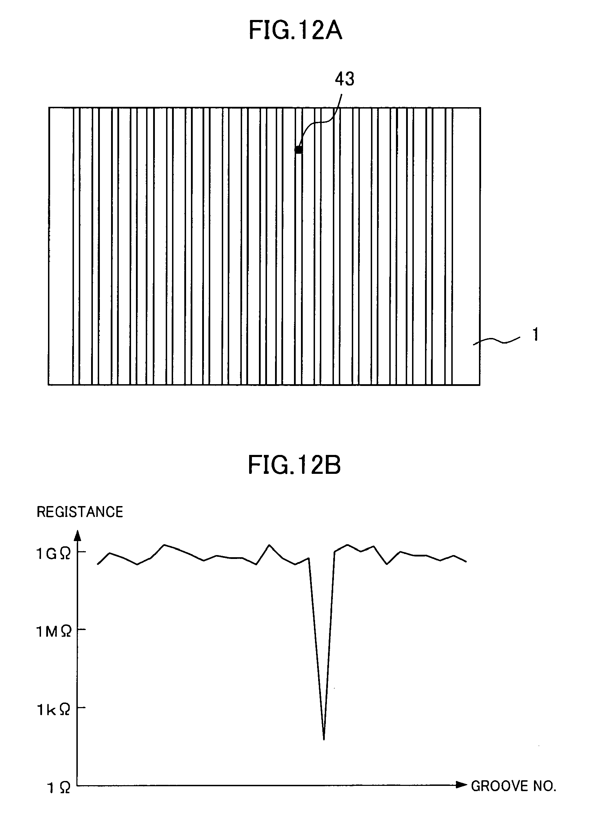

Figs. 10 and 11 show the apparatus according to the fourth embodiment as viewed from the y direction and x direction, respectively and Figs. 12A and 12B concern a resistance measurement result in the fourth embodiment.

Reference numeral 1 denotes a substrate, 2 a stage, 3x an x-axis moving mechanism, 4 a laser optics system, 5 laser light, 6 a condenser lens, 7 laser-processed grooves, 8 an objective lens, 9 a mirror, 10 an observation device, 13 a mechanism for blowing off foreign matter, 41a and 41b probes, and 42 an insulation resistance tester.

In this embodiment, the substrate 1 is under the process for P1 or P3.

As the stage 2 is moved in the y direction by the y-axis moving mechanism 3y as shown in Fig. 11, the substrate 1 is irradiated (scanned) with laser light 5 to form laser-processed grooves 7. Each time the stage 2 is traveled once in the y direction for scanning, the x-axis moving mechanism 3x moves the stage 2 in the +x direction as shown in Fig. 1 by a given distance d so that laser-processed grooves 7 are formed at regular intervals of d as illustrated in Fig. 10.

As illustrated in Fig. 10, the objective lens 8 is spaced by distance d from the condenser lens 6 in the +x direction. Light from the objective lens 8 is led through the mirror 9 into the observation device 10. As a consequence, the width, depth, and roughness of the processed grooves 7 can be observed immediately after they are formed.

In this embodiment, the probes 41a and 41b are spaced from the condenser lens in the +x direction by distance d (distance between grooves or interval suitable for the cell size) as illustrated in Fig. 10, and they are located at one end of the substrate 1 in the y direction as illustrated in Fig. 11. In addition, the probes 41a and 41b are incorporated in the stage 2, considering that laser light is irradiated on the reverse of the film surface of the substrate 1.

When the substrate 1 is moved in the x direction, the probes 41a and 41b are kept off the substrate 1 as indicated by dotted lines and when the substrate 1 does not move in the x direction, they are in contact with the substrate 1 as indicated by solid lines. The probes 41a and 41b are both connected with the insulation resistance tester 42 and while they are in contact with the substrate 1, the resistance between the probes is monitored. As a consequence, immediately after a groove 7 is formed, the insulation condition of the groove 7 can be tested.

As in the first embodiment, the spacing between the objective lens 8 and the condenser lens 6 may be md (m: an integer) and the spacing between the probe 41a (41b) and the condenser lens 6 may be nd (n: an integer).

Fig. 12A shows an example of a processed substrate 1 and Fig. 12B shows the result of resistance measurement of the substrate 1. In Fig. 12B, the horizontal axis represents the number of a processed groove which corresponds to a groove shown in Fig. 12A. The vertical axis represents the resistance of a groove. It is demonstrated here that while the resistances of normally processed grooves are 1 G ohms or so and enough to provide required insulation, there is one groove whose resistance is exceptionally small or about 1 k ohms. This is due to the presence of a short circuit spot 43 as shown in Fig. 12A. If such poor insulation is found, the part of the corresponding groove which is abnormal in terms of width, depth and roughness can be located by the observation device 10. In order to locate such a defective part by the observation device 10, the confocal laser scanning microscope or dark-field microscope as used in the second or third embodiment may be used.

The part thus decided as defective is moved back to beneath the condenser lens 6 and may be repaired by irradiating it with laser light again or blowing off foreign matter again. If the substrate concerned is found to be irreparable, it can be discarded immediately.

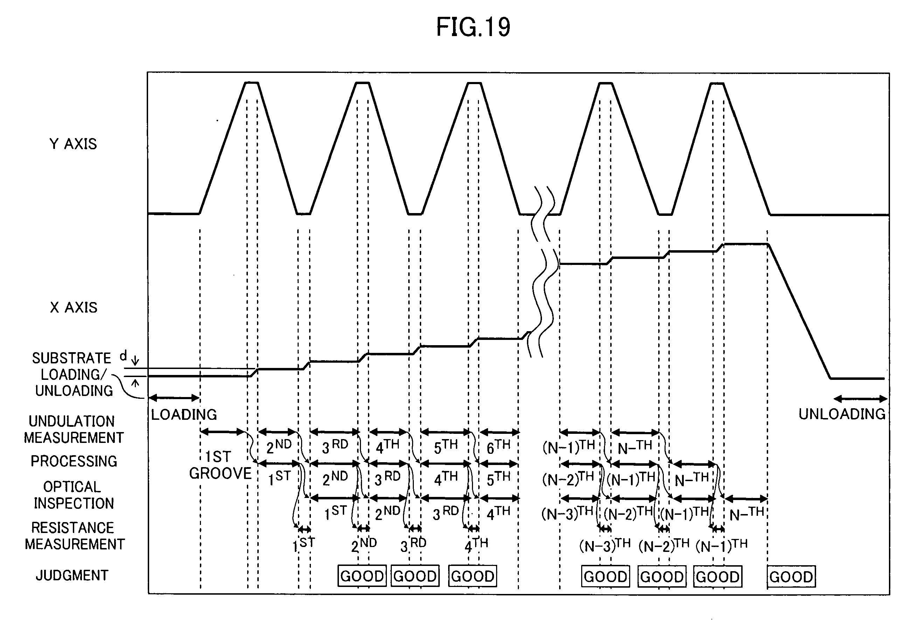

Fig. 19 is a time diagram concerning different steps: movement of the stage, undulation measurement, processing, and inspection. In the figure, the step of resistance measurement is added to the diagram in Fig. 16. Thus, in this embodiment, resistance measurement is made immediately after processing and the result of resistance measurement can be combined with the result of optical inspection to judge whether a groove is good or not.

Since ends of the substrate are usually not used to generate electricity and the probes are located at an end of the substrate as illustrated in Fig. 11, traces of the probe needles in the film cause no problem.

In this embodiment, since electrical inspection is made in this way, a processing defect can be quickly detected with high sensitivity. Also, in combination with optical inspection, a defective part can be easily located and the part concerned can be repaired quickly or a decision to discard the substrate can be made promptly. In addition, in the manufacture of solar cells, the yield and TAT can be substantially improved.

### Fifth Embodiment

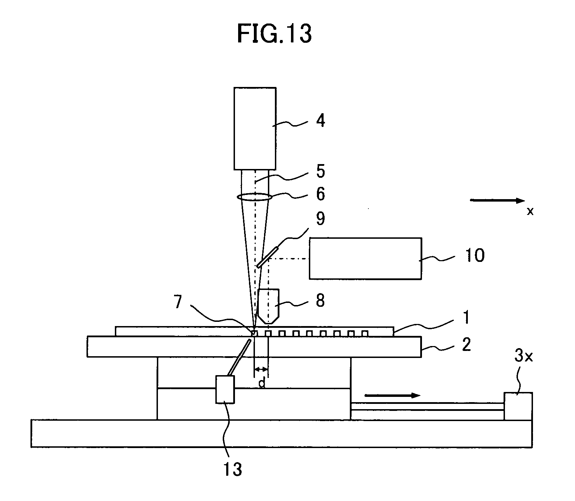

Next, a fifth embodiment of the invention will be described referring to Fig. 13. Regarding things that have been described concerning the first to fourth embodiments and are not described below, they also hold true for the fifth embodiment.

Fig. 13 shows the apparatus according to the fifth embodiment as viewed from the y direction. Reference numeral 1 denotes a substrate, 2 a stage, 3x an x-axis moving mechanism, 3y a y-axis moving mechanism, 4 a laser optics system, 5 laser light, 6 a condenser lens, 7 laser-processed grooves, 8 an objective lens, 9 a mirror, 10 an observation device, and 13 a mechanism for blowing off foreign matter. Though it is hidden in Fig. 13, there is a y-axis moving mechanism 3y behind the stage 2.

This embodiment is a simplified version of the apparatus according to the first embodiment, where the displacement gauge light source 11, displacement gauge photo-detector 12, and focusing mechanism 14 are omitted. This embodiment is useful when the focal depth of the condenser lens 6 is large and the influence of undulation of the substrate 1 is small.

As the stage 2 is moved in the y direction as shown in Figs. 2 and 3 by the y-axis moving mechanism 3y, the substrate 1 is irradiated (scanned) with laser light 5 to form laser-processed grooves 7. Each time the stage 2 is traveled once in the y direction for scanning, the x-axis moving mechanism 3x moves the stage 2 in the x direction as shown in Fig. 13 by a given distance d so that laser-processed grooves 7 are formed at regular intervals of d as illustrated in Fig. 13.

As illustrated in Fig. 13, the objective lens 8 of the optical inspection section is spaced by distance d from the condenser lens 6 in the +x direction. Light from the objective lens 8 is led through the mirror 9 into the observation device 10. As a consequence, the width, depth, and roughness of the processed grooves 7 can be observed.

In this embodiment, two steps, laser radiation and observation, can be carried out simultaneously as in the first embodiment. Since the same stage is used to scan the substrate 1 in these two steps, no special means is needed for alignment between the point of laser radiation and the point of observation and alignment with the same point can be made accurately. Therefore, process time can be substantially shortened and alignment errors in inspection can be substantially reduced as compared with a conventional laser processing apparatus which uses another device to observe processed grooves.

Since the result of observation is obtained just after laser processing in this way, a defect can be detected at an early stage of the process. Specifically, if a defect is found by observation, the defective part can be moved back to beneath the condenser lens 6 to reprocess it. If the defect is found to be irreparable, it can be discarded immediately. Consequently, as compared with a case that an inspection is made after completion of all the processes for films P1 to P3, the possibility of a defective substrate going to a subsequent process is remarkably decreased and waste in processing is substantially reduced.

As described above, in this embodiment, a processing defect can be quickly detected through a simple structure. Also, in this embodiment, the yield and TAT in the manufacture of solar cells can be improved by using a substrate 1 whose undulation is less influential and a condenser lens with a large focal depth.

### Sixth Embodiment

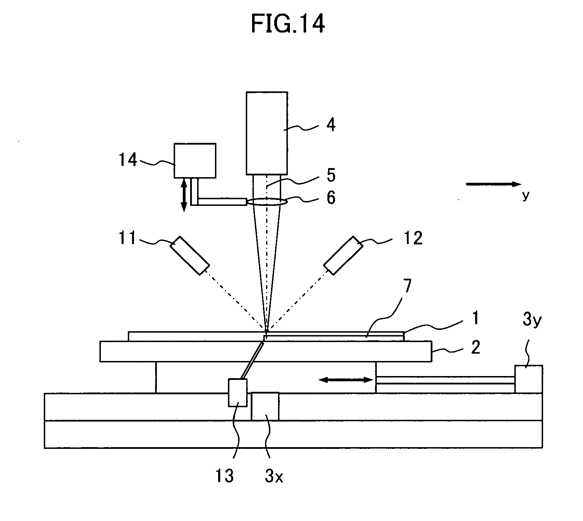

Next, a sixth embodiment of the invention will be described referring to Fig. 14. Regarding things that have been described concerning the first to fourth embodiments and are not described below, they also hold true for the sixth embodiment.

Fig. 14 shows the apparatus according to the sixth embodiment as viewed from the x direction. Reference numeral 1 denotes a substrate, 2 a stage, 3x an x-axis moving mechanism, 3y a y-axis moving mechanism, 4 a laser optics system, 5 laser light, 6 a condenser lens, 7 laser-processed grooves, 11 a displacement gauge light source, 12 a displacement gauge photo-detector, 13 a mechanism for blowing off foreign matter, and 14 a focusing mechanism.

This embodiment is a simplified version of the apparatus according to the first embodiment, where the observation device 10 is omitted. This embodiment is useful when a stable laser light source is used and processing defects can be reduced sufficiently just by compensation for the influence of the undulation of the substrate 1.

In this embodiment two steps, laser radiation and displacement measurement, can be carried out simultaneously as in the first embodiment. Since the same stage is used to scan the substrate 1 in these two steps, no special means is needed for alignment between the point of laser radiation and the point of displacement measurement, and alignment with the same point can be made accurately. Therefore, processing time can be substantially shortened and positioning errors in measurement can be substantially reduced as compared with a conventional laser processing apparatus which uses another device to measure undulation of the substrate.

Another distinct feature is that the result of undulation measurement of the substrate 1 can be quickly reflected in the laser processing conditions. Specifically, by changing the vertical position or height of the condenser lens 6 according to the result of measurement by the displacement gauge photo-detector 12, laser light 5 is always focused on the target spot of the film properly even if the substrate is considerably wavy or undulating. For example, if laser light 5 is condensed on a spot of tens of microns and the spot is tens of microns away from the target spot, blurring will occur, resulting in a processing defect. This embodiment solves this problem and reduces or prevents occurrences of processing defects.

Although undulation of the substrate 1 is measured in this embodiment, the displacement gauge light source 11 and displacement gauge photo-detector 12 may be replaced by a film thickness measuring instrument. If that is the case, the film thickness distribution of the substrate is measured before processing, so, even if there is a considerable change in film thickness, the laser light intensity can be set according to the change in film thickness and thus processing defects can be substantially reduced. Furthermore, since it does not matter that such a film thickness measuring instrument is installed along with the displacement gauge light source 11 and displacement gauge optical photo-detector 12, it is also possible to specify the processing conditions according to both the substrate undulation and film thickness distribution.

Therefore, according to this embodiment, since the undulation measurement section and the laser radiation section are fixed and kept in a given positional relationship, the result of undulation measurement is accurately reflected in the point of laser radiation and the focal position, leading to reduction in processing defects. In addition, the yield and TAT in the manufacture of solar cells can be improved by the use of a stable laser light source.

### Seventh Embodiment

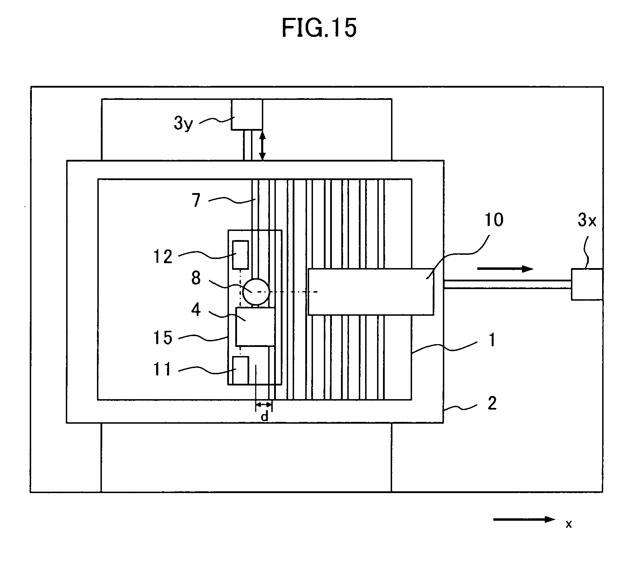

Next, a seventh embodiment of the invention will be described referring to Fig. 15. Regarding things that have been described concerning the first to fifth embodiments and are not described below, they also hold true for the seventh embodiment.

Fig. 15 shows the apparatus according to the fifth embodiment as viewed from the z direction. Reference numeral 1 denotes a substrate, 2 a stage, 3x an x-axis moving mechanism, 3y a y-axis moving mechanism, 4 a laser optics system, 7 laser-processed grooves, 8 an objective lens, and 10 an observation device.

This embodiment is the same as the first embodiment except that the laser optics system 4 and objective lens 8 are positioned above the same processed groove 7. Specifically, while in the first embodiment a processed groove is observed after its formation and movement of the stage in the x direction by distance d, in the seventh embodiment the same groove is observed immediately after its formation. This embodiment is different from the first embodiment only in the positional relationship between the laser optics system 4 and the objective lens 8.

According to this embodiment, a processing defect can be easily located and reprocessing can be promptly done or a decision to discard the substrate can be made immediately. Particularly, since the same groove being formed by laser radiation is inspected, even if a processing defect is detected, there is no need to move back in the -x direction by distance d and a remedial action can be taken more immediately than in the first embodiment. In addition, the yield and TAT in the manufacture of solar cells can be improved.

## Claims

1. A laser processing apparatus comprising:
a stage for carrying a substrate on which a thin film is formed;
a laser radiation section for irradiating laser light on the thin film formed on the substrate placed on the stage to form grooves in the thin film; and
a drive for scanning the substrate for the laser radiation section;
the apparatus further comprising:
a measurement section or inspection section for making a measurement or inspection of the substrate or the thin film;
wherein the laser radiation section irradiates laser light on the substrate being scanned; and
wherein the measurement section or the inspection section makes a measurement or an inspection of the substrate being scanned and irradiated with laser light, simultaneously with the laser radiation.

2. The laser processing apparatus according to Claim 1,
Wherein, during the measurement or inspection, the laser radiation section, which is performing the laser radiation, and the measurement section or the inspection section are kept in a given positional relationship; and
wherein a point of laser radiation on the substrate and the point of measurement or the point of inspection on the substrate are kept in a given positional relationship.

3. The laser processing apparatus according to Claim 1 or 2, comprising the inspection section, wherein the inspection section inspects a groove formed by the laser radiation.

4. The laser processing apparatus according to Claim 3,
wherein the laser radiation section forms a plurality of grooves in the substrate; and
wherein the inspection section inspects a groove that is under the laser radiation.

5. The laser processing apparatus according to Claim 3,
wherein the laser radiation section forms a plurality of grooves in the substrate; and
wherein the inspection section inspects a groove other than a groove under the laser radiation.

6. The laser processing apparatus according to Claim 3,
wherein the inspection section is an optical inspection section for inspecting the grooves optically; and
wherein the optical inspection section includes a confocal laser scanning microscope or dark-field microscope.

7. The laser processing apparatus according to Claim 3,
wherein the inspection section is an electrical inspection section for inspecting the grooves electrically; and
wherein the electrical inspection section, with two probes contacting both sides of film sandwiching a laser-processed groove, measures electric resistance between the probes.

8. The laser processing apparatus according to any one of Claims 3 to 7,
wherein a groove judged as defective by the inspection is reprocessed by the laser radiation section.

9. The laser processing apparatus according to Claim 1 or 2,
wherein the measurement section is a measurement section which measures the substrate's undulation or the thin film's thickness; and
wherein a focal position or laser light intensity of the laser radiation section is determined according to a result of measurement by the measurement section at a point on the substrate where the measurement section has made a measurement.

10. The laser processing apparatus according to any one of Claims 1 to 9,
wherein the thin film is transparent conductive film, silicon film or a laminate of transparent conductive film and silicon film.

11. The laser processing apparatus according to Claim 10,
wherein the transparent conductive film is ZnO film or SnO film and the silicon film is amorphous silicon film or microcrystal silicon film.

12. A method for manufacturing thin-film solar cells, comprising the steps of:
preparing a substrate;
forming transparent conductive film on the substrate;
forming a first groove in the transparent conductive film;
forming an electricity-generating layer on the transparent conductive film having the first groove;
forming a second groove in the electricity-generating layer;
forming a conductive film on the electricity-generating layer having the second groove; and
forming a third groove in a laminate of the conductive film and the electricity-generating layer;
wherein the laser processing apparatus according to any one of Claims 1 to 11 is used to form at least one of the first, second and third grooves.

13. A laser processing method comprising the steps of:
placing a substrate on which a thin film is formed, on a stage; and
performing laser radiation and measurement or inspection of the substrate simultaneously while scanning the substrate on the stage.

14. The laser processing method according to Claim 13, wherein laser radiation and measurement or inspection are performed while a point of laser radiation and a point of measurement or inspection on the substrate are kept in a given positional relationship.
